# EUROPEAN PATENT APPLICATION

(11) **EP 1 435 724 A1**
(43) Date of publication of application: **07.07.2004**
(21) Application number: 02425798.2
(22) Date of filing: 30.12.2002
(51) Int. Cl.: H04N 1/00

(54) **Housing**

(71) Applicant: MOTOROLA, INC., Schaumburg, IL 60196 (US)
(72) Inventor: Caci, Vincenzo, Motorola Technology Center, 10147 Torino (IT); Cattaneo, Dino, Motorola Technology Center, 10147 Torino (IT); Giacosa, Fausto, Motorola Technology Center, 10147 Torino (IT); Tasselli, Corrado, Motorola Technology Center, 10147 Torino (IT)
(74) Representative: Gibson, Sarah Jane

(57) **Abstract**

The present invention relates to a housing, in particular a housing for an electronic device having at least two function sets. The housing has two housing portions that can rotate relative to one another to select different function sets. The housing preferably also has function modules corresponding to function sets, where the different relative positions of the housing portions select different function modules.

## Description

The present invention relates to a novel housing, in particular for an electronic device. The housing in accordance with the present invention is particularly applicable to a housing for an electronic device having a number of different function sets or capabilities.

A number of different types of electronic device housings are known.

In the field of communication devices, such as mobile telephones, many different types of housing form factors are known. In some, such as a clam form factor or a U-flip form factor, two housing portions are connected by a hinge and are able to rotate between an open and a shut position.

Increasingly hardware to support additional functional features of the communication devices, such as a camera, is bene added to mobile telephones. The camera may be built into the mobile phone, or may be extended or removed therefrom.

In the field of personal digital assistants it is common for the main housing of the personal digital assistant to be provided with a cover portion hinged along one long side in a book-like manner. However, the cover generally only provides protection for the main housing.

In contrast, in the field of electronic entertainment devices, the configuration of the housing is generally fixed.

The present invention seeks to provide a new housing of an electronic device.

According to the present invention, there is provided a housing, for an electronic device having at least two function sets, the housing having first and second housing portions arranged to rotate relative to one another between at least a first and a second relative position to select a respective first and second function set.

Preferably, the housing has at least one function module, the or each function module being associated with a respective function set. The function modules are preferably disposed between the housing portions. Most preferably at least one of the different positions of the housings relative to each other selects a different function module and a function set associated therewith.

Advantageously, when the housings are positioned to select a function module and associated function set, a display carried by the first housing portion is aligned with the function module.

Advantageously at least one function module is moveable between a retracted position in which the function module is at least substantially contained within or between the first and second housing portions and an extended position in which the function module is extended from the first and second housing portions. Most advantageously, the extension of the module relative to the housing occurs automatically on selection of the respective function set.

In an advantageous embodiment a single function set is associated with two function modules.

For a better understanding of the present invention, and to show how it may be brought into effect, reference will now be made, by way of example, to the accompanying drawings, in which:
Figure 1 shows a 3-dimensional view of the main elements of a housing in accordance with an embodiment of the invention;
Figure 2 shows an exploded cross-sectional view of an electronic device having a housing in accordance with an embodiment of the invention;
Figure 3 is a plan view of the second housing portion 12 shown in Figures 1 and 2;
Figure 4 is an illustrative arrangement of the electrical connections within the housing of Figures 1-3;
Figure 5 shows further detail of the electrical connections within the housing of Figures 1-3.

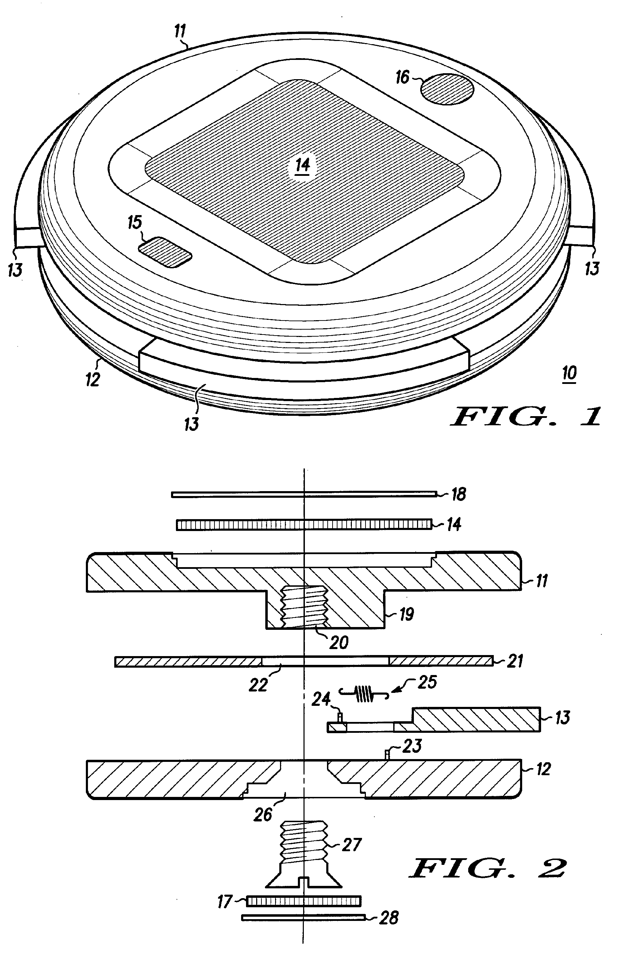

Figure 1 illustrates an exemplary embodiment of a housing 10 of an electronic device, such as a communication device, in accordance with the present invention. The housing 10 has a first housing portion 11 and a second housing portion 12. The first housing portion 11 and the second housing portion 12 are preferably substantially the same size and shape, ie are preferably substantially congruent. In the illustrateci exemplary embodiment, the first housing portion 11 and the second housing portion 12 are generally circular, although it will be appreciated that other shapes are possible. The first and second housing portions 11, 12 are preferably substantially fiat.

The first and second housing portions 11, 12 are coupled to each other (in a manner which is not shown in Figure 1, but which will be explained later) and are able to rotate relative to each other. In the illustrated arrangement, the first and second housing portions are arranged to rotate around an axis substantially in the centre of the first and second housing portion, although other arrangements are possible.

The illustrated exemplary embodiment of the housing also has function modules 13 disposed between the first and the second housing portions 11, 12. The function modules 13 are preferably moveable between a retracted position, as shown, in which the function module is at least substantially contained within or between the first and second housing portions 11,12 and a second, extended position (not shown) in which the function module is extended from the first and second housing portions 11,12. The details of operation of a function module 13 between the retracted position and the extended position will be explained in more detail hereafter.

The electronic device housing preferably has at least one function module 13.

Each function module 13 is associated with a function set of the electronic device and carries hardware relating to the function set of the electronic device. Thus, for example, a function module 13 may carry a numerical keypad and/or a text keypad (for example a QWERTY keypad) to enter text or numbers to the electronic device and/or, if the electronic device is a wireless communication device, to enter a phone number to enable the communication device to initiate a call, for example, or to send a text message, for example using the Short

Message Service (SIVIS) of the GSM/EDGE/UMTS wireless communication systems etc. Alternatively, a function module may carry a camera or may carry hardware adapted for playing games, for example a joystick. Alternatively, a function module may carry a speaker and/or microphone; a polyphonic speaker; a sound recorder; a radio tuner; plug connectors, for example.

It is not necessari for a function set to be associated with a function module. For example, a simple phone function set may use a microphone, speaker and keypad provided on one or both of the housing portions.

Ideally, each function module 13 carries hardware relating to a single function set of the electronic device. However, in some situations, it may be advantageous for two or more function modules 13 to be associated with a single function set, for example a keypad may be carried on two adjacent function modules 13, or left-hand and right hand gaming controls may be carried on adjacent function modules.

In one advantageous arrangement of a function module 13 at least a portion of at least one of the function modules 13 is detachable from the electronic device. The function module, or the detached portion of the function module, may be coupled to the electronic device by a wire, or may communicate with the electronic device by means of a short-range wireless link, e.g. via a Bluetooth™ link or an Infra red link to exchange information with the main part of the electronic device. Alternatively, information gathered or recorded by a function module when detached may be stored locally in the function module. This information may be uploaded to the main part of the electronic device, or information may be downloaded from the main part of the electronic device when the function module is re-attached to the main part of the electronic device. For example if the detachable function module 13 incorporates a camera, the images recorded while the camera function module is detached from the electronic device may be stored in a memory of the camera function module and may be uploaded to the electronic device, for example for further processing or for wireless transmission in a Multimedia Messaging Service (MIVIS) message, once the camera function module 13 has been re-attached to the electronic device. A similar situation may arise if the function module is a sound recorder.

The illustrated exemplary first housing portion 11 carries a display 14, which may be a touch screen display, for displaying information to the user of the electronic device, and possibly for receiving information from the user of the electronic device.

Advantageously, if the electronic device is a communication device, the first housing portion 11 also carries a microphone 15 and a speaker 16 to enable the user of the communication device to make and receive calls. Of course, it is also possible for the microphone/speaker functionality to be provided by a function module 13. Preferably, the second housing portion 12 also carries a display 17 (not shown). In an advantageous embodiment of the invention, the display 17 displays secondary information, such as date & time information, and/or caller id information when the electronic device is a communication device.

The structural relationship of the main parts of the electronic device housing identified above is shown by Figure 2 which is an exploded cross-sectional view of an electronic device having a housing in accordance with an embodiment of the invention.

As explained above, the display 14 is fitted to the outer side of the first housing portion 11. The display 14 is preferably a Liquid Crystal Display (LCD) and a covering lens 18 is preferably fitted to the outer side of the first housing portion 11 to protect the LCD 14 and to enhance the display characteristics of the LCD 14, as is known to a skilled person.

The first housing portion 11 carries a cam 19 which has a threaded hole 20 formed therein as, shown. The first housing portion 11 also carries thereon a printed circuit board (PCB) 21, which is provided to carry the electronic circuitry for the electronic device, such as processing and memory integrated circuits (not shown). A skilled person will know the type of electronic circuitry required for the electronic device, and will be able to design a suitable PCB design, so the PCB design will not be discussed further.

Typically at least one memory circuit will be provided containing software relating to function sets corresponding to the functions provided by the electronic device. The software relating to a particular function set is accessed in response to a specific relative positioning of the first and second housing portions 11,12.

The PCB 21 is shaped and sized so as to be contained entirely within the perimeter of the first housing portion 11. In addition, the PC13 21 has a slot 22 therein through which the cam 19 protrudes when the PCB 21 is fitted to the first housing portion 11.

Only one function module 13 is shown in Figure 2 for clarity. The function module 13 is carried by the second housing portion 12, as will be explained in more detail hereafter. In the illustrated embodiment of the invention, the second housing portion 12 and the function module 13 have respective pins 23 and 24 attached to them, and a spring 25 is disposed between pins 23 and 24 as shown. Clearly, the second housing portion 12 and the function module 13 may alternatively be connected by other connecting features, such as holes, holders, hooks etc, as will be apparent to a skilled person. In addition the second housing portion 12 is provided with ribs (not shown in Figure 2) to guide movement of the function modules. This will be explained in more detail hereafter.

The second housing portion 12 has a smooth hole 26 formed therethrough. A screw 27 is passed through smooth hole 26 and is fastened to the threaded hole 20 in the cam 19/first housing portion 11. Therefore the second housing portion 12, carrying the function modules 13, is able to rotate freely with regard to the first housing portion 11 and the cam 19 and PCB 21 attached thereto, while being securely attached thereto.

Clearly, the relative motion of the first and second housing portions 11, 12 may be achieved in other ways which will be apparent to a skilled person, and which are intended to be included within the scope of the present invention. The display 17, mentioned previously, is fitted to the second housing portion 12. Again, preferably display 17 is an LCD 17 and has a lens 28 fitted thereto to protect the LCD 17 and to enhance the display characteristics of the LCD 17.

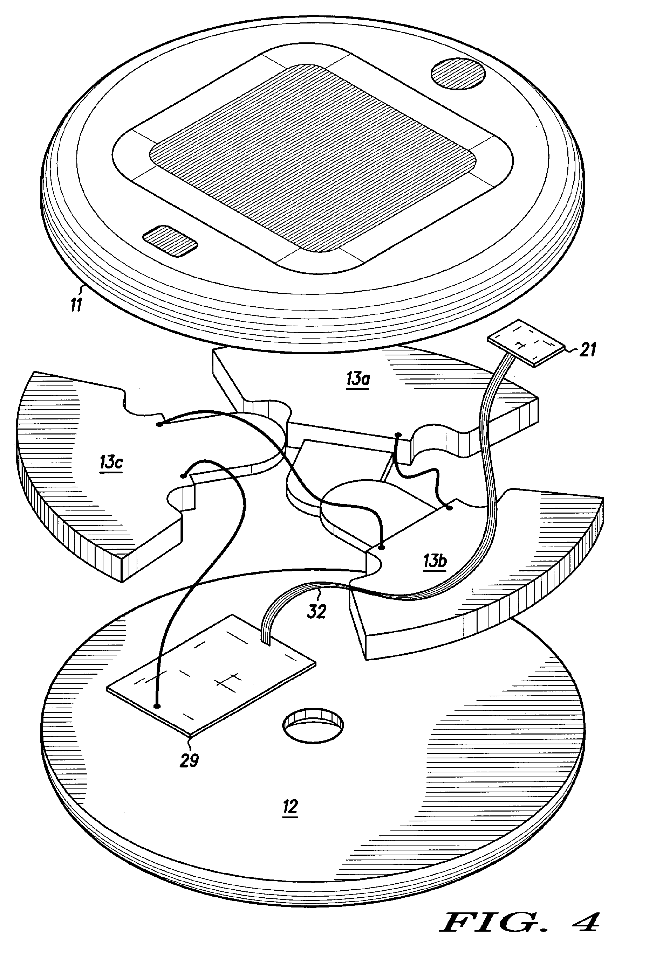

Finally, the second housing portion 12 may have a secondary PCB 29 (not shown) mounted thereon thereto, as will be described later with reference to Figure 4. Advantageously, secondary PCB 29 is disposed under the function module(s) 13 and fixed to the second housing portion 12. The secondary PCB may have holes or openings formed therein, corresponding to the ribs 30. Alternatively, if the dimensions of the function module(s) 13 and the second housing portion 12 allow sufficient free space, the PCB 29 may be disposed around or between the function module(s) 13.

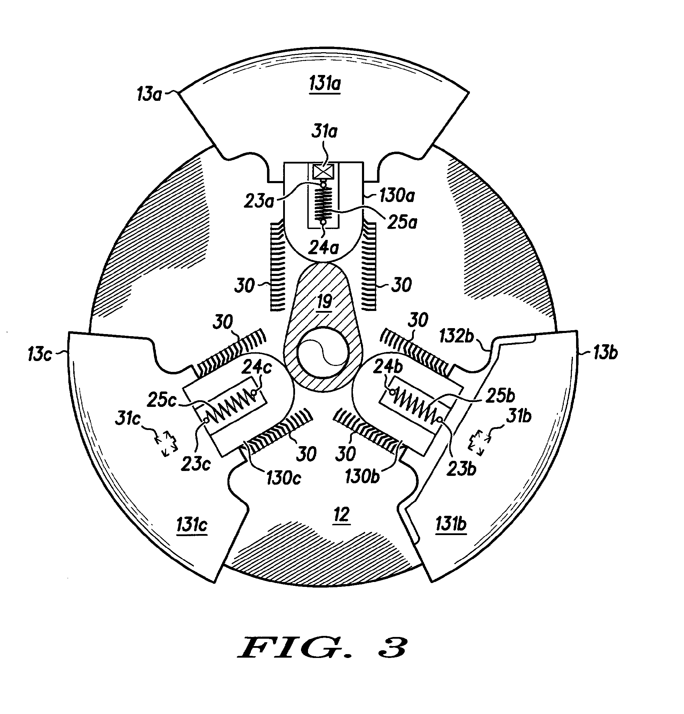

Further detail of the fitting of the function modules 13 to the second housing portion 12 in the illustrated embodiment of the invention to enable relative movement of the function module 13 and the second housing portion 12 between a retracted position of the function module 13 and an extended position of the function module 13 in accordance with a preferred embodiment of the invention, is shown in Figure 3.

The described arrangement enables automatic extension of the function modules 13 when the first and second housing portions are rotated relative to one another. Clearly, although such an arrangement is advantageous, it is not necessary for the extension of the function modules to occur automatically, and it is possible for the extension of the function module to be extended manually by the user of the electronic device.

Figure 3 is a plan view of the second housing portion 12, also showing the cam 19 that is attached to the first housing portion 11 as described above with reference to Figure 2.

Three function modules 13a, 113b and 13c are shown in the exemplary arrangement shown in Figure 3. Each of the function modules 13a, 13b, 13c has an arm portion, 130a, 1130b and 130c and a head portion 131a, 131b, 131c. Each arm portion 130a, 1130b and 130c has a pin 24a, 24b, 24c which is coupled to a respective spring 25a, 25b, 25c. The other end of the respective spring 25a, 25b and 25c is coupled to a respective pin 23a, 23b, 23c on the second housing portion 12.The springs are in held in compressioni and thus exert a force radially inward on the respective arm portions 130a, 130b, 130c.

Furthermore, the second housing portion 12 has a plurality of ribs 30 disposed thereon, one each side of and adjacent to the arm portion 130a, 130b, 130c of the function modules 13a, 13b, 13c. These ribs 30 act as guides during the extension and retraction movement of the function modules 13a, 13b, 13c.

In the position shown, the first housing portion 11 and the second housing portion 12 are oriented such that a larger radius part of cam 19 is adjacent the function module 13a, whereas smaller radius parts of cam 19 are adjacent the function modules 13b and 13c. Thus it can be seen that the larger radius part of the cam 19 has, against the force exerted by the spring 25a, pushed the arm portion 130a radially outwardly guided by ribs 30 thus moving the function module 13a to the extended position. As is clearly shown in Figure 3, the head portion 131 a of the function module 13a can now be accessed by the user of the electronic device.

Since the smaller radius parts of cam 19 are adjacent the function modules 13b and 13c there is no resistance to the inwards force of the springs 25b and 25c and the function modules 13b and 13c remain retracted.

Clearly, the cam shape necessary to achieve the described operation can be determined by a skilled person. In addition, a skilled person would be able to select a cam shape to select two function modules simultaneously.

The second housing portion 12 also has a switch 31a, 31b and 31c provided for each of the illustrated function modules. As illustrated, the switches 31a, 31b and 31c are positioned on the second housing 12, or more preferably on the secondary PCB 29 (not shown), such that when a function module 13 is in the extended position, such as function module 13a, the corresponding switch 31 is activated. in contrast, when a function module 13 is in the retracted position, such as function modules 113b and 13c, the corresponding switches 31b and 31c are not activated. The activation signals from the switches 31a, 31b and 31c may be passed to the PCB 21 from the secondary PCB 29, as described hereafter.

The activation of the switch 31a is detected, and the function set of the electronic device corresponding to the function module 13a is selected. For example, the corresponding software function set will be activated on detection of the activation of the respective switch.

Thus, in the illustrated embodiment, the relative rotation of the first and second housings to a specific relative position results in the movement of a function module to its extended position together with the selection of the corresponding function set of the electronic device. The user of the electronic device may then utilize the function provided by the function module 13a.

However, it is not necessary for the selection of a function set of the electronic device to be responsive to the automatic extension of the corresponding function module. Instead, the selection of the function set of the electronic device may be made directly responsive to a specific relative position of the first and second housing portions. This is particularly valuable in embodiments of the invention in which one or more function set is not associated with a function module, but only with a specific relative position of the housings, or embodiments of the invention in which the function module is not movable at all, or is manually movable between the retracted position and the extended position.

The detection of the relative position of the first and the second housing portions 11,12 may be achieved in a number of ways that will be apparent to a skilled person. For example, the first and second housing portions 11, 12 may be provided with mechanic or magnetic switches which are activated only at certain relative positions of the first and second housing portions 11, 12.

As mentioned previously, it is possible for at least part of a function module 13 to be detachable from the housing. Function module 13b as shown in Figure 3 has a latch portion 132b connecting the arm portion 130b and the head portion 131b.
When the function module 13b moves into an extended position, the user can operate the latch portion 132b to detach the head portion 131b from the arm portion 130b. A suitable latch mechanism will be known by a person skilled in the art. Clearly other arrangements are possible to enable the function module to become detached, as will be known to a skilled person.

It is not necessary for function module(s) to be radially movable between a retracted position and an extended position. For example, the function module(s) may be arranged to rotate about an axis at the edge of at least one housing portion to move between a retracted position and an extended position.

Details of the electrical connections between the PCB 21 carrying the electronic circuitry for the electronic device and the function modules 13 of the electronic device in accordance with an embodiment of the invention, will now be described with reference to Figure 4. It will be understood by a skilled person that the electrical connections formed between the PCB 21 and the function modules 13 may be used for the supply of power to the function modules and/or the exchange of signals between the PCB 21 and a function module 13.

Figure 4 is an illustrative arrangement of the electrical connections within the housing. As such, further details of the construction of the housing are not shown.

The illustrative embodiment of the invention shown in Figure 4 has three function modules 13a, 13b and 13c disposed within the first and second housing portions 11, 12. It will be appreciated that although Figure 4 is an expanded view to illustrate the electrical connections more clearly, in fact the function modules are disposed within the first and second housing portions 11, 12 as explained with reference to Figures 1-3.

In the illustrative arrangement shown in Figure 4, function module 13a is electrically connected to function module 13b, which in turn is electrically connected to function module 13c, which in turn is electrically connected to the secondary PCB 29 carried by the second housing portion 12. In turn, the secondary PCB 29 is electrically connected to PCB 21 via electrical connection 32. Clearly, it would also be possible for the function modules 13a, 13b, 13c to each be connected directly to the secondary PCB 29.

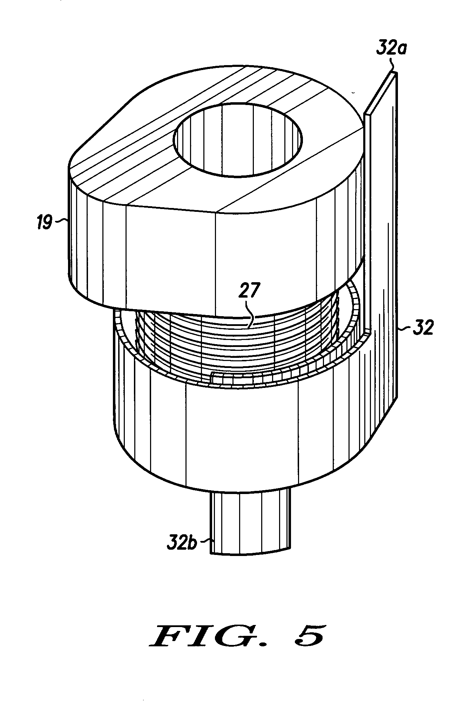

In one embodiment of the invention, the electrical connection 32 between the PCB 21 and the secondary PCB 29 is provided by a flex connector 32. To allow relative movement between the first housing portion 11 and the second housing portion 12, the flex connector 32 may be wound around the shaft of the screw 27 as shown in Figure 5, with respective ends 32a, 32b being connected to a suitable connector mounted on PCB 21 and secondary PCB 29.

Clearly, the use of a flex connector 32 in accordance with the illustrated embodiment of the invention does not allow for indefinite relative rotation between the first housing portion 11 and the second housing portion 12.
Accordingly, it is necessary to limit the relative rotation of the first and the second housing portions 11, 12. This may be achieved simply by means of two stoppers, for example ribs, provided on the first and second housing portions 11, 12.

Alternatively, it would be possible to provide a connection similar to that provided on the Motorola ™ v70 mobile telephone, which provides electrical connection between two housing portions while enabling indefinite relative rotation in either direction.

Alternatively, a wireless internal connection, for example IRDA or Bluetooth ™, may be used to connect the PCB 21 and the secondary PCB 29.

Thus the function modules are able to exchange signals and power, as necessary, with the PCB 21. In this arrangement, it is envisaged that the secondary PCB 29 acts merely as a gathering point for the wiring between the function modules 13 and the memory/processing circuits on the PCB 21.
However, some processing or storage etc functions, advantageously relating to the function module(s) 13, may be carried out on the secondary PCB 29.

Thus a user of an electronic device having a housing in accordance with the invention is able to select different function sets of the electronic device merely by moving the housing portions to different relative positions. In particular, the software corresponding to the different function sets of the electronic device is selected according to the different relative position.

Preferably any hardware corresponding to the different functions of the electronic device are carried on function modules. The selection of different function modules can be viewed as equivalent to the selection of a corresponding function set.

From the preceding description it can be seen that the present invention provides an advantageous housing for an electronic device.

The invention is not intended to be limited by the preceding description, but instead is limited only by the accompanying claims.

## Claims

1. A housing, for an electronic device having at least two function sets, the housing having first and second housing portions arranged to move relative to one another between at least a first and a second relative position to select a respective first and second function set.

2. The housing as claimed in claim 1, further comprising at least one function modules, the or each function module being associated with a respective function set.

3. The housing as claimed in claim 2 wherein at least one of the different positions of the housings relative to each other selects a different function module and a function set associated therewith.

4. The housing as claimed in claim 3 wherein when the housings are positioned to select a function module and associated function set, a display carried by the first housing portion is aligned with the function module.

5. The housing as claimed in one of claims 2-4 wherein at least one function module is moveable between a retracted position in which the function module is at least substantially contained within or between the first and second housing portions and an extended position in which the function module is extended from the first and second housing portions.

6. The housing as claimed in claim 5 having means to make the extension of the at least one function module relative to the housing automatic on selection of the respective function set.

7. The housing as claimed in claim 5 or 6 wherein the at least one function module moves radially between the retracted position and the extended position.

8. The housing as claimed in claim 5 or 6 wherein the at least one function module rotates about an axis at the edge of at least one of the housing portions to move between the retracted position and the extended position.

9. The housing as claimed in one of claims 2-8. wherein at least part of at least one of the function modules is substantially detachable from the housing.

10. The housing as claimed in one of claims 2-9 wherein the or each function module carries one of: a camera; a keypad; a keyboard; a joystick; a speaker; a microphone; a loudspeaker; polyphonic speaker, sound recorder; radio tuner; plug connectors;

11. The housing as claimed in one of claims 2-10 wherein a single function set is associated with two function modules.

12. The housing as claimed in any preceding claim wherein the first and second housing portions are arranged to rotate around an axis substantially in the centre of the first and second housing portions.

13. The housing as claimed in any preceding claim wherein the first and second housing portions are substantially congruent.

14. An electronic device having a housing as claimed in any preceding claim.

15. A communication device having a housing as claimed in any one of claims 1-13.
